# EUROPÄISCHE PATENTSCHRIFT

(11) **EP 1 990 330 B1**
(45) Veröffentlichungstag und Bekanntmachung des Hinweises auf die Patenterteilung: **29.06.2011**
(21) Anmeldenummer: 07009129.3
(22) Anmeldetag: 07.05.2007
(51) Int. Cl.: C04B 35/468, C04B 35/01, C04B 35/50, C23C 28/00, C23C 30/00, C23C 4/10

(54) **Keramisches Pulver, keramische Schicht und Schichtsystem mit Pyrochlorphase und Oxiden**
Ceramic powder, ceramic layer and layer system containing a pyrochlorphase and oxides
Poudre céramique, couche céramique et système de couche comportant une phrase pyrochlore et des oxydes

(43) Veröffentlichungstag der Anmeldung: 12.11.2008
(60) Teilanmeldung: 10013925.2
(73) Patentinhaber: SIEMENS AKTIENGESELLSCHAFT, 80333 München (DE)
(72) Erfinder: Subramanian, Ramesh, Dr., 10777 Berlin (DE)

(56) Entgegenhaltungen:
- EP-A- 1 783 248
- EP-A- 1 806 432
- EP-A- 1 806 435
- WO-A-2005/019370
- US-A1- 2004 106 015

## Beschreibung

Die Erfindung betrifft ein keramisches Pulver, eine keramische Schicht und ein Schichtsystem mit Pyrochloren und Oxiden gemäß den Ansprüchen 1, 15 und 16.

Ein solches Schichtsystem weist ein Substrat mit einer Metalllegierung auf der Basis von Nickel oder Kobalt auf. Derartige Erzeugnisse dienen vor allem als Bauteil einer Gasturbine, insbesondere als Gasturbinenschaufeln oder Hitzeschilde. Die Bauteile sind einem Heißgasstrom von aggressiven Verbrennungsgasen ausgesetzt. Daher müssen sie hohen thermischen Belastungen Stand halten können. Des Weiteren ist es erforderlich, dass diese Bauteile oxidations- und korrosionsbeständig sind. Vor allem an bewegliche Bauteile, z. B. Gasturbinenschaufeln, aber auch an statische Bauteile sind fernerhin mechanische Anforderungen zu stellen. Die Leistung und der Wirkungsgrad einer Gasturbine, in der heißgasbelastbare Bauteile Verwendung finden, steigen mit zunehmender Betriebstemperatur. Um einen hohen Wirkungsgrad und eine hohe Leistung zu erzielen, werden durch die hohen Temperaturen besonders belastete Komponenten der Gasturbinen mit einem keramischen Werkstoff beschichtet. Dieser wirkt als Wärmedämmschicht zwischen dem Heißgasstrom und dem metallischen Substrat.
Vor dem aggressiven Heißgasstrom wird der metallische Grundkörper durch Beschichtungen geschützt. Dabei weisen moderne Bauteile zumeist mehrere Beschichtungen auf, die jeweils spezifische Aufgaben erfüllen. Es liegt somit ein Mehrschichtsystem vor.
Da Leistung und Wirkungsgrad von Gasturbinen mit zunehmender Betriebstemperatur steigen, wurde immer wieder versucht, durch Verbesserung des Beschichtungssystems eine höhere Leistungsfähigkeit von Gasturbinen zu erzielen.

Die EP 0 944 746 B1 offenbart die Verwendung von Pyrochloren als Wärmedämmschicht. Jedoch sind für den Einsatz eines Materials als Wärmedämmschicht nicht nur gute wärmedämmende Eigenschaften notwendig, sondern auch gute mechanische Eigenschaften sowie eine gute Anbindung an das Substrat.

Die EP 0 992 603 A1 offenbart eine Wärmedämmschichtsystem aus Gadoliniumoxid und Zirkonoxid, das keine Pyrochlorstruktur aufweist.

Die US 2004/0106015 A1 offenbart ein Pulver und Wärmedämmshicht, die eine Pyrochlorstruktur aufweisen.

Es ist daher Aufgabe der Erfindung, ein keramisches Pulver, eine keramische Schicht und ein Schichtsystem aufzuzeigen, das gute wärmedämmende Eigenschaften sowie eine gute Anbindung an das Substrat und damit eine lange Lebensdauer des gesamten Schichtsystems aufweist.

Der Erfindung liegt die Erkenntnis zugrunde, dass das gesamte System als Einheit betrachtet werden muss und nicht einzelne Schichten oder einzelne Schichten untereinander isoliert von einander betrachtet und optimiert werden dürfen, um eine lange Lebensdauer zu erzielen.

Die Aufgabe wird gelöst durch ein keramisches Pulver, eine keramische Schicht und ein Schichtsystem gemäß den Ansprüchen 1, 15 oder 16.

In den Unteransprüchen sind weitere vorteilhafte Maßnahmen aufgeführt, die beliebig in vorteilhafter Art und Weise kombiniert werden können.

Es zeigen
- Figur 1: ein erfindungsgemäßes Schichtsystem,
- Figur 2: eine Liste von Superlegierungen,
- Figur 3: eine perspektivische Ansicht einer Turbinenschaufel,
- Figur 4: eine perspektivische Ansicht einer Brennkammer,
- Figur 5: eine Gasturbine.

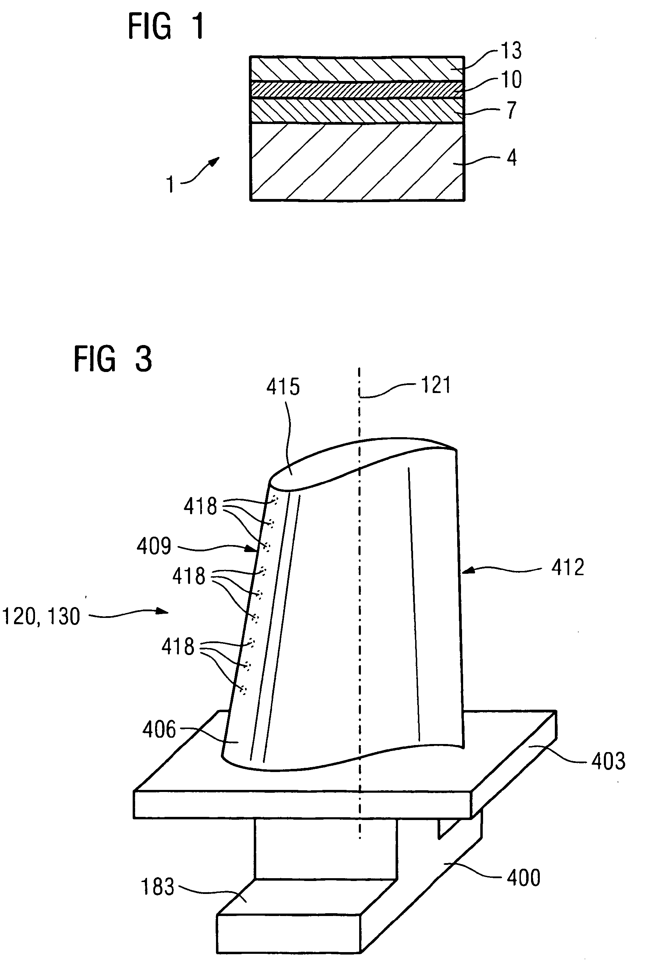

Das erfindungsgemäße keramische Pyrochlorpulver der allgemeinen Formel A₂B₂O₇ weist als weiteren Bestandteil ein Oxid CᵣOₛ eines Metalls (O = Sauerstoff; B = Hf, Zr, Ti, Sn; A = Gd, Sm, Nd, La, Y) auf. Der Metallbestandteil des Sekundär-Oxids wird hier mit C gekennzeichnet.
Die Zusammensetzung des keramischen Pulvers wird auch anhand der Zusammensetzung der keramischen Schicht 13 (Fig. 1) beispielhaft erläutert.
Generell können immer Abweichungen von der Stöchiometrie der allgemeinen Pyrochlorstruktur A₂B₂O₇ auftreten.

Pyrochlorstrukturen, bei denen A = Gadolinium ist, werden bevorzugt verwendet, da hier gute bis sehr gute Wärmedämmeigenschaften erreichen werden. Je nach Anwendung wird ein Hafnat oder Zirkonat verwendet, so dass B = Hafnium oder Zirkonium darstellt.

Vorzugsweise wird also Gadoliniumhafnat oder Gadoliniumzirkonat verwendet.

Gadoliniumhafnat weist als Pulver 43wt% bis 50wt%, vorzugsweise 44,7wt% bis 47,7wt% Gadoliniumoxid und Rest Hafniumoxid und die Sekundär-Oxide, vorzugsweise nur Zirkonoxid, und die Sinterhilfen auf.

Gadoliniumzirkonat weist als Pulver 56wt% bis 63wt%, vorzugsweise 58wt% bis 61wt% Gadoliniumoxid und Rest Zirkonoxid und die Sekundär-Oxide, vorzugsweise nur Hafniumoxid, und Sinterhilfen auf.

Die keramische Schicht 13 (Fig. 1) oder das keramische Pulver weist eine Pyrochlorphase der allgemeinen Summenformel AₓB_{y}C_{z} mit x, y ≈ 2, z ≈ 7 und ein Sekundär-Oxid CᵣOₛ mit r, s > 0 auf.
Das Sekundär-Oxid CᵣOₛ wird bewusst zu dem Pulver hinzugefügt, liegt also deutlich über der messtechnischen Nachweisgrenze des Sekundär-Oxids, also weist mindestens den doppelten Wert der Nachweisgrenze des Sekundär-Oxids auf.

Das Sekundär-Oxid weist einen Anteil von 0,5wt% bis 10wt% auf, ganz insbesondere einen Anteil von 1wt% bis 10wt%.
Der maximale Anteil des Sekundär-Oxids liegt vorzugsweise bei 8wt%,
insbesondere maximal bei 6wt% und ganz insbesondere zwischen 5wt% und 7wt%.
Der maximale Anteil des Sekundär-Oxids liegt ebenso vorzugsweise bei 3wt%, insbesondere maximal bei 2wt% und ganz insbesondere zwischen 1,5wt% und 2,5wt%.
Insbesondere besteht das keramische Pulver aus zumindest einer Pyrochlorphase und zumindest einem Sekundär-Oxid.

Für das Sekundär-Oxid wird nicht das Oxid von B verwendet (C ≠ B).
Wenn B ≠ C ist, so wird jedoch eine Erhöhung der mechanischen Festigkeit erreicht.

Es werden deshalb Hafniumoxid oder Zirkonoxid verwendet, da diese besonders hochtemperaturstabil sind und es nicht zu Diffusionen und damit zu einer Phasenveränderung der Pyrochlorstruktur kommt.

Die keramische Schicht 13 oder das keramische Pulver weist nur eine Pyrochlorphase auf, so dass beim Einsatz mit stark wechselnden Temperaturen keine thermischen Spannungen zwischen unterschiedlichen Phasen auftreten.

Vorzugsweise weist die keramische Schicht 13 oder das keramische Pulver nur ein Sekundär-Oxid auf.
Das Sekundär-Oxid kann Hafniumoxid oder Zirkonoxid darstellen.

Ebenso können zwei Sekundär-Oxide, insbesondere Hafniumoxid und Zirkonoxid verwendet werden, damit die mechanischen Eigenschaften weiter verbessert werden.

Dabei können die Sekundär-Oxide vorzugsweise nur als Oxid vorliegen, so dass hier eine Sekundärphase vorliegt, die zur mechanischen Verstärkung führt oder sie liegen als Mischkristall untereinander oder mit der Pyrochlorphase vor, so dass dadurch die thermische Leitfähigkeit durch die dadurch erzeugten Spannungen im Gitter weiter reduziert werden.

Um Vorteile aus beiden Darstellungsarten der Sekundär-Oxide zu ziehen, können das oder die Sekundär-Oxide sowohl als Oxid oder als Mischkristall in der Pyrochlorphase vorliegen.

Es ist B ≠ C.
So weist ein Pyrochlorpulver aus Gadoliniumzirkonat, insbesondere Gd₂Zr₂O₇, Hafniumoxid, insbesondere mit einem Anteil von 1,5wt% bis 2,5wt%, insbesondere 2wt% auf. Vorzugsweise weist Gadoliniumhafnat, insbesondere Gd₂Hf₂O₇, Zirkonoxid, insbesondere mit einem Anteil von 5wt% bis 7wt%, insbesondere bis 6wt%, auf.

Vorzugsweise weist bzw. weisen das Pyrochlor bzw. weisen die Pyrochlore folgende optionale Bestandteile als Sinterhilfe auf:

| | |
|---|---|
| bis 0,05wt% | Siliziumoxid, |
| bis 0,1wt% | Kalziumoxid, |
| bis 0,1wt% | Magnesiumoxid, |
| bis 0,1wt% | Eisenoxid, |
| bis 0,1wt% | Aluminiumoxid, |
| bis 0,08wt% | Titanoxid. |

Beim Beschichten oder beim späteren Einsatz bei höheren Temperaturen führen diese Sinterhilfen zu dichten und stabilen Schichten.
Vorzugsweise werden keine weiteren Sinterhilfen verwendet.

Figur 1 zeigt ein erfindungsgemäßes Schichtsystem 1.

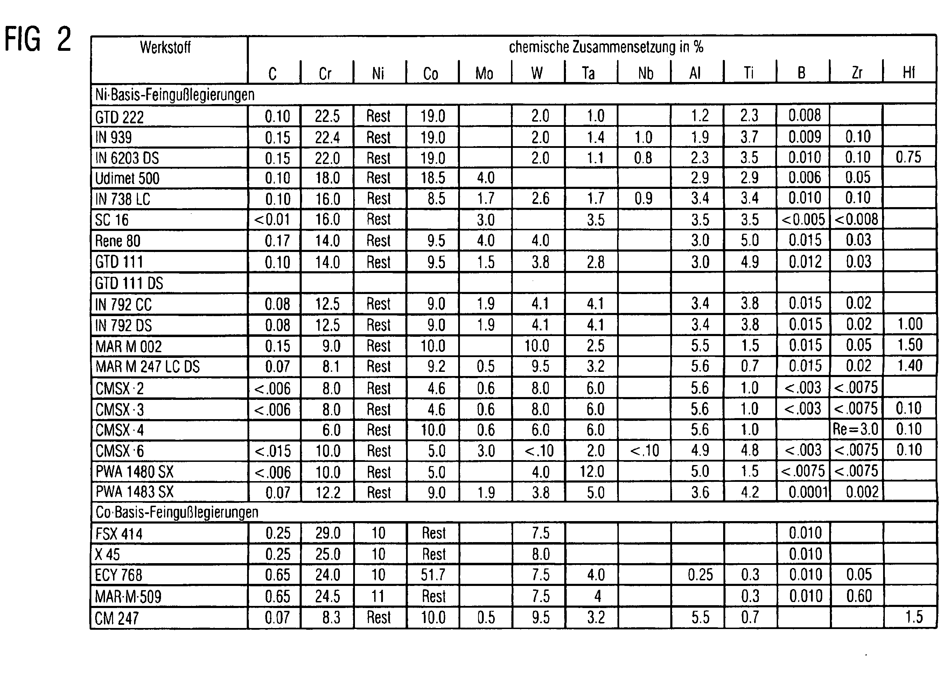

Das Schichtsystem 1 weist ein metallisches Substrat 4 auf, das insbesondere für Bauteile bei hohen Temperaturen aus einer nickel- oder kobaltbasierten Superlegierung (Fig. 2) besteht.
Vorzugsweise direkt auf dem Substrat 4 ist vorzugsweise eine metallische Anbindungsschicht 7 insbesondere des Typs NiCoCrALX vorhanden, die vorzugsweise
(11 - 13)wt% Kobalt, (20 - 22)wt% Chrom, (10,5 - 11,5)wt% Aluminium, (0,3 - 0,5)wt% Yttrium, (1,5 - 2,5)wt% Rhenium und Rest Nickel oder die
vorzugsweise (24 - 26)wt% Kobalt, (16 - 18)wt% Chrom, (9,5 - 11)wt% Aluminium, (0,3 - 0,5)wt% Yttrium, (1 - 1,8)wt% Rhenium und Rest Nickel aufweist, insbesondere daraus besteht.

Auf dieser metallischen Anbindungsschicht 7 ist vorzugsweise bereits vor dem Aufbringen weiterer keramischer Schichten eine Aluminiumoxidschicht entstanden oder während des Betriebs entsteht eine solche Aluminiumoxidschicht (TGO).

Auf der metallischen Anbindungsschicht 7 oder auf der Aluminiumoxidschicht (nicht dargestellt) oder auf dem Substrat 4 ist vorzugsweise eine innere keramische Schicht 10, vorzugsweise eine vollständig oder teilweise stabilisierte Zirkonoxidschicht vorhanden. Vorzugsweise wird Yttriumstabilisiertes Zirkonoxid verwendet, wobei vorzugsweise 6wt% - 8wt% Yttrium verwendet wird. Ebenso kann Kalziumoxid, Ceroxid und/oder Hafniumoxid zur Stabilisierung von Zirkonoxid verwendet werden.
Das Zirkonoxid wird vorzugsweise als plasmagespritzte Schicht aufgetragen, kann vorzugsweise auch als kolumnare Struktur mittels Elektronenstrahlverdampfen (EBPVD) aufgebracht werden.

Auf der stabilisierten Zirkonoxidschicht 10 oder auf der metallischen Anbindungsschicht 7 oder auf dem Substrat ist eine äußere keramische Schicht 13 aus dem keramischen Pulver aufgebracht.
Vorzugsweise stellt die Schicht 13 die äußerste Schicht dar, die dem Heißgas direkt ausgesetzt ist.
Die Schicht 13 besteht zum größten Teil aus einer Pyrochlorphase, also mindestens 90wt% der Pyrochlorphase auf, die vorzugsweise entweder aus Gd₂Hf₂O₇ oder Gd₂Zr₂O₇ besteht.

Die Sekundär-Oxide sind in der Schicht 13 verteilt, vorzugsweise homogen verteilt.

Die Schichtdicke der inneren Schicht 10 beträgt vorzugsweise zwischen 10% und 50%, insbesondere zwischen 10% und 40% der Gesamtschichtdicke von innerer Schicht 10 und äußerer Schicht 13.
Die innere keramische Schicht 10 hat vorzugsweise eine Dicke von 100µm bis 200µm, insbesondere 150µm ± 10%.
Die Gesamtschichtdicke von der inneren Schicht 10 und der äußeren Schicht 13 beträgt vorzugsweise 300µm oder vorzugsweise 450µm. Die maximale Gesamtschichtdicke beträgt vorteilhafterweise 600µm oder vorzugsweise maximal 800µm.

Vorzugsweise liegt die Schichtdicke der inneren Schicht 10 zwischen 10% und 40% oder zwischen 10% und 30% der Gesamtschichtdicke.
Ebenso vorteilhaft ist es, wenn die Schichtdicke der inneren Schicht 10 10% bis 20% der Gesamtschichtdicke aufweist. Ebenso vorzugsweise ist es, wenn die Schichtdicke der inneren Schicht 10 zwischen 20% und 50% oder zwischen 20% und 40% der Gesamtschichtdicke beträgt.
Wenn der Anteil der inneren Schicht 10 an der Gesamtschichtdicke zwischen 20% und 30% liegt, werden ebenso vorteilhafte Ergebnisse erzielt.
Vorzugsweise beträgt die Schichtdicke der inneren Schicht 10 30% bis 50% der Gesamtschichtdicke.
Ebenso vorteilhaft ist es, wenn die Schichtdicke der inneren Schicht 10 30% bis 40% der Gesamtschichtdicke aufweist. Ebenso vorzugsweise ist es, wenn die Schichtdicke der inneren Schicht 10 zwischen 40% und 50% der Gesamtschichtdicke beträgt.

Für den Kurzzeiteinsatz bei hohen Temperaturen des Schichtsystems kann die äußere Schicht 13 vorzugsweise dünner als die innere Schicht 10 ausgeführt sein, also beträgt die Schichtdicke der äußeren Schicht 13 maximal 40% der Gesamtschichtdicke aus innerer Schicht 10 und äußerer Schicht 13.

Vorzugsweise besteht das Schichtsystem aus Substrat 4, metallischer Schicht 7, innerer keramischer Schicht 10 und äußerer keramischer Schicht 13 sowie optional der TGO.

Figur 3 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 auf.
Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.
Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures).
Solche Verfahren sind aus der US-PS 6,024,792 und der EP 0 892 090 A1 bekannt.

Ebenso können die Schaufeln 120, 130 Beschichtungen gegen Korrosion oder Oxidation aufweisen, z. B. (MCrAlX; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1.

Auf der MCrAlX kann noch eine erfindungsgemäße keramische Wärmedämmschicht 13 vorhanden sein.

Durch geeignete Beschichtungsverfahren wie z.B. Elektronenstrahlverdampfen (EB-PVD) werden stängelförmige Körner in der Wärmedämmschicht erzeugt.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

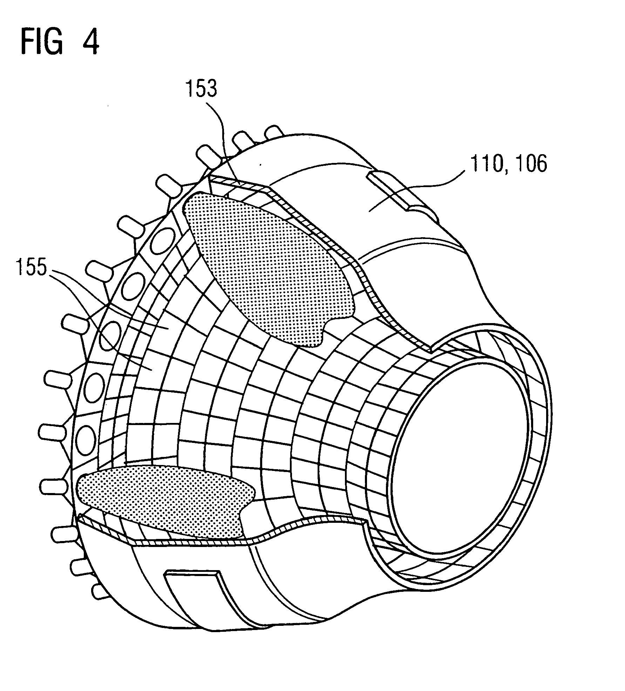

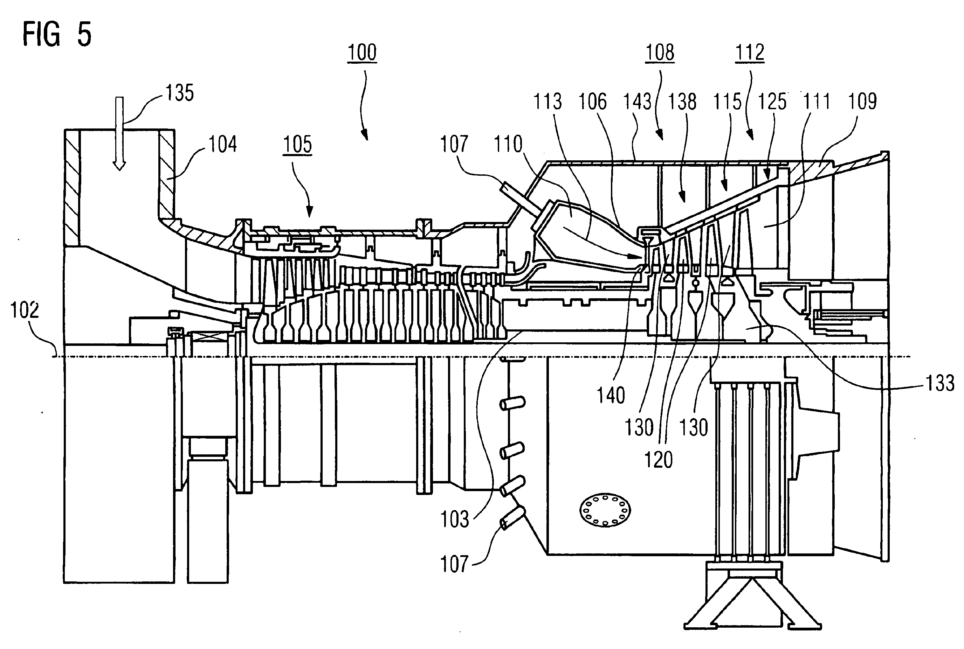

Die Figur 4 zeigt eine Brennkammer 110 einer Gasturbine 100 (Fig. 5).
Die Brennkammer 110 ist beispielsweise als so genannte Ringbrennkammer ausgestaltet, bei der eine Vielzahl von in Umfangsrichtung um eine Rotationsachse 102 herum angeordneten Brennern 107 in einen gemeinsamen Brennkammerraum 154 münden, die Flammen 156 erzeugen. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.

Jedes Hitzeschildelement 155 aus einer Legierung ist arbeitsmediumsseitig mit einer besonders hitzebeständigen Schutzschicht (MCrAlX-Schicht und/oder keramische Beschichtung) ausgestattet oder ist aus hochtemperaturbeständigem Material (massive keramische Steine) gefertigt.
Diese Schutzschichten können ähnlich der Turbinenschaufeln sein, also bedeutet beispielsweise MCrAlX: M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf). Solche Legierungen sind bekannt aus der EP 0 486 489 B1, EP 0 786 017 B1, EP 0 412 397 B1 oder EP 1 306 454 A1.

Wiederaufarbeitung (Refurbishment) bedeutet, dass Hitzeschildelemente 155 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse in dem Hitzeschildelement 155 repariert. Danach erfolgt eine Wiederbeschichtung der Hitzeschildelemente 155 und ein erneuter Einsatz der Hitzeschildelemente 155.

Aufgrund der hohen Temperaturen im Inneren der Brennkammer 110 kann zudem für die Hitzeschildelemente 155 bzw. für deren Halteelemente ein Kühlsystem vorgesehen sein. Die Hitzeschildelemente 155 sind dann beispielsweise hohl und weisen ggf. noch in den Brennkammerraum 154 mündende Filmkühllöcher (nicht dargestellt) auf.

Die Figur 5 zeigt beispielhaft eine Gasturbine 100 in einem Längsteilschnitt.
Die Gasturbine 100 weist im Inneren einen um eine Rotationsachse 102 drehgelagerten Rotor 103 mit einer Welle 101 auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.
Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.
Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.
Um den dort herrschenden Temperaturen standzuhalten, können diese mittels eines Kühlmittels gekühlt werden.
Ebenso können Substrate der Bauteile eine gerichtete Struktur aufweisen, d.h. sie sind einkristallin (SX-Struktur) oder weisen nur längsgerichtete Körner auf (DS-Struktur).
Als Material für die Bauteile, insbesondere für die Turbinenschaufel 120, 130 und Bauteile der Brennkammer 110 werden beispielsweise eisen-, nickel- oder kobaltbasierte Superlegierungen verwendet.
Solche Superlegierungen sind beispielsweise aus der EP 1 204 776 B1, EP 1 306 454, EP 1 319 729 A1, WO 99/67435 oder WO 00/44949 bekannt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

## Patentansprüche

1. Keramisches Pulver,
das nur eine Pyrochlorphase der Summenformel AₓB_{y}O_{z} mit x, y ≈ 2, z ≈ 7 und
ein Sekundär-Oxid CᵣOₛ mit r, s > 0 aufweist, insbesondere mit einem Anteil für das Sekundär-Oxid von 0,5 wt% bis 10 wt%,
bei dem C = Hafnium (Hf) ist oder bei dem C = Zirkon (Zr) ist
bei dem B =Hafnium (Hf) ist oder bei dem B =Zirkon (Zr) ist.
und C ≠ B.

2. Keramisches Pulver nach Anspruch 1,
bei dem A = Gadolinium (Gd) ist.

3. Keramisches Pulver nach Anspruch 1,
das maximal 3wt%,
insbesondere maximal 2wt% und
ganz insbesondere 1,5 wt% bis 2,5wt% eines Sekundär-Oxids aufweist.

4. Keramisches Pulver nach Anspruch 1,
das maximal 8wt%,
insbesondere maximal 6wt% und
ganz insbesondere 5wt% bis 7wt%
eines Sekundär-Oxids aufweist.

5. Keramisches Pulver nach Anspruch 1, oder 3,
bei dem das Sekundär-Oxid Hafniumoxid (HfO₂) ist.

6. Keramisches Pulver nach Anspruch 1, oder 14,
bei dem das Sekundär-Oxid Zirkonoxid (ZrO₂) ist.

7. Keramisches Pulver nach einem oder mehreren der Ansprüche 1 bis 6,
das als Sinterhilfe aufweist:
bis 0,05wt% Siliziumoxid,
bis 0,1wt% Kalziumoxid,
bis 0,1wt% Magnesiumoxid,
bis 0,1wt% Eisenoxid,
bis 0,1wt% Aluminiumoxid,
bis 0,08wt% Titanoxid.

8. Keramisches Pulver nach einem oder mehreren der vorherigen Ansprüche,
das nur ein Sekundär-Oxid CᵣOₛ aufweist.

9. Keramisches Pulver nach einem oder mehreren der vorherigen Ansprüche,
das nur zwei Sekundär-Oxide CᵣOₛ und C'_{r'}O_{s'} aufweist.

10. Keramisches Pulver nach einem oder mehreren der vorherigen Ansprüche,
bei dem das Sekundär-Oxid oder die Sekundär-Oxide nur als Oxid vorliegen.

11. Keramisches Pulver nach einem oder mehreren der vorherigen Ansprüche 1 bis 10,
bei dem das Sekundär-Oxid oder die Sekundär-Oxide vollständig als Mischkristall vorliegen.

12. Keramisches Pulver nach einem oder mehreren der vorherigen Ansprüche 1 bis 10,
bei dem das Sekundär-Oxid oder die Sekundär-Oxide sowohl als Oxid als auch als Mischkristall vorliegen.

13. Keramisches Pulver nach einem oder mehreren der vorherigen Ansprüche 1 bis 12,
das aus Pyrochlorphasen A₂B₂O₇,
Oxiden,
und Sinterhilfen besteht.

14. Keramisches Pulver nach einem oder mehreren der vorherigen Ansprüche 1 bis 13,
das aus Pyrochlorphasen,
Sekundär-Oxiden CᵣOₛ
und ohne Sinterhilfen gemäß Anspruch 7 besteht.

15. Keramische Schicht (13),
hergestellt aus einem keramischen Pulver nach einem oder mehreren der vorherigen Ansprüche 1 bis 14,
insbesondere ausschließlich hergestellt aus einem keramischen Pulver nach einem oder mehreren der vorherigen Ansprüche 1 bis 14.

16. Schichtsystem,
aufweisend
ein Substrat (4) und
eine keramische Schicht (13) nach Anspruch 19,
die insbesondere die äußerste Schicht (13) darstellt.

17. Schichtsystem nach Anspruch 16,
aufweisend
eine metallische Anbindungsschicht (7),
die (7) insbesondere eine NiCoCrAlX-Legierung aufweist, insbesondere daraus besteht.

18. Schichtsystem nach Anspruch 16 oder 17,
das eine innere keramische Schicht (10),
insbesondere auf der metallischen Anbindungsschicht (7), insbesondere eine stabilisierte Zirkonoxidschicht, insbesondere eine Yttrium-stabilisierte Zirkonoxidschicht aufweist,
wobei auf der inneren keramischen Schicht (10) die keramische Schicht (13) vorhanden ist.

19. Schichtsystem nach Anspruch 18,
bei dem die innere Schicht (10) eine Schichtdicke zwischen 10% und 50%,
insbesondere zwischen 10% und 40%,
der Gesamtschichtdicke der inneren Schicht (10) und der äußeren Schicht (13) aufweist.

20. Schichtsystem nach Anspruch 18,
bei dem die innere Schicht (10) eine Schichtdicke zwischen 10% und 30% der Gesamtschichtdicke der inneren Schicht (10) und der äußeren Schicht (13) aufweist.

21. Schichtsystem nach Anspruch 18,
bei dem die innere Schicht (10) eine Schichtdicke zwischen 20% und 40% der Gesamtschichtdicke der inneren Schicht (10) und der äußeren Schicht (13) aufweist.

22. Schichtsystem nach Anspruch 18,
bei dem die innere Schicht (10) eine Schichtdicke zwischen 50% und 90%,
insbesondere zwischen 60% und 90%,
der Gesamtschichtdicke der inneren Schicht (10) und der äußeren Schicht (13) aufweist.

23. Schichtsystem nach Anspruch 18,
bei dem die innere Schicht (10) eine Schichtdicke zwischen 70% und 90% der Gesamtschichtdicke der inneren Schicht (10) und der äußeren Schicht (13) aufweist.

24. Schichtsystem nach Anspruch 18,
bei dem die innere Schicht (10) eine Schichtdicke zwischen 60% und 80% der Gesamtschichtdicke der inneren Schicht (10) und der äußeren Schicht (13) aufweist.

25. Schichtsystem nach einem oder mehreren der Ansprüche 18 bis 24,
bei dem die innere Schicht (10) eine Schichtdicke von
100µm bis 200µm aufweist,
insbesondere 150µm ± 50µm.

26. Schichtsystem nach Anspruch 17,
bei dem die metallische Anbindungsschicht (7) die Zusammensetzung (in wt%)
11% - 13% Kobalt,
20% - 22% Chrom,
10,5% -11,5% Aluminium,
0,3% - 0,5% Yttrium,
1,5% - 2,5% Rhenium und
Rest Nickel aufweist,
insbesondere daraus besteht.

27. Schichtsystem nach Anspruch 17,
bei dem die metallische Anbindungsschicht (7) die Zusammensetzung (in wt%)
24% - 26% Kobalt,
16% - 18% Chrom,
9,5% - 11% Aluminium,
0,3% - 0,5% Yttrium,
1% - 1,8% Rhenium und
Rest Nickel aufweist,
insbesondere daraus besteht.

28. Schichtsystem nach Anspruch 18,
bei dem die Yttrium-stabilisierte Zirkonoxidschicht 6wt% -
8wt% Yttrium aufweist.

29. Schichtsystem nach Anspruch nach einem oder mehreren der Ansprüche 18 bis 25,
bei dem die Gesamtschichtdicke der inneren Schicht (10) und der äußeren Schicht (13) mindestens 300µm beträgt, insbesondere 300µm.

30. Schichtsystem nach einem oder mehreren der Ansprüche 18 bis 25,
bei dem die Gesamtschichtdicke der inneren Schicht (10) und der äußeren Schicht (13) mindestens 450µm beträgt, insbesondere 450µm.

31. Schichtsystem nach einem oder mehreren der Ansprüche 18 bis 25,
bei dem die Gesamtschichtdicke maximal 600µm, insbesondere maximal 800µm beträgt.

32. Schichtsystem nach einem oder mehreren der vorherigen Ansprüche, substrat (4),
das aus einem Substrat (4),
einer metallischen Schicht (7),
einer inneren keramischen Schicht (10) und
einer äußeren keramischen Schicht (13) besteht.

33. Schichtsystem nach einem oder mehreren der vorherigen
Ansprüche,
das aus einem Substrat (4),
einer metallischen Schicht (7),
einer Oxidschicht auf der metallischen Schicht (7), einer inneren keramischen Schicht (10) und
einer äußeren keramischen Schicht (13) besteht.

## Claims

1. Ceramic powder,
which comprises only a pyrochlore phase of the empirical formula AₓB_{y}O_{z} with x, y ≈ 2, z ≈ 7 and
a secondary oxide CᵣOₛ with r, s > 0,
with a proportion of from 0.5 wt% to 10 wt% for the secondary oxide,
wherein C = hafnium (Hf) or wherein C = zirconium (Zr), wherein B = hafnium (Hf) or wherein B = zirconium (Zr) and C ≠ B.

2. Ceramic powder according to Claim 1,
wherein A = gadolinium (Gd).

3. Ceramic powder according to Claim 1,
which comprises at most 3 wt%,
in particular at most 2 wt% and
more particularly between 1.5 wt% and 2.5 wt% of a secondary oxide.

4. Ceramic powder according to Claim 1,
which comprises at most 8 wt%,
in particular at most 6 wt% and
more particularly between 5 wt% and 7 wt%
of a secondary oxide.

5. Ceramic powder according to Claim 1 or 3,
wherein the secondary oxide is hafnium oxide (HfO₂).

6. Ceramic powder according to Claim 1 or 4,
wherein the secondary oxide is zirconium oxide (ZrO₂).

7. Ceramic powder according to one or more of Claims 1 to 6, which comprises as sintering aids:
up to 0.05 wt% of silicon oxide,
up to 0.1 wt% of calcium oxide,
up to 0.1 wt% of magnesium oxide,
up to 0.1 wt% of iron oxide,
up to 0.1 wt% of aluminum oxide and
up to 0.08 wt% of titanium oxide.

8. Ceramic powder according to one or more of the preceding claims,
which comprises only one secondary oxide CᵣOₛ.

9. Ceramic powder according to one or more of the preceding claims,
which comprises only two secondary oxides CᵣOₛ and C'_{r'}O_{s'}.

10. Ceramic powder according to one or more of the preceding claims,
wherein the secondary oxide or the secondary oxides are present only as an oxide.

11. Ceramic powder according to one or more of the preceding Claims 1 to 10,
wherein the secondary oxide or the secondary oxides are entirely present as a mixed crystal.

12. Ceramic powder according to one or more of the preceding Claims 1 to 10,
wherein the secondary oxide or the secondary oxides are present both as an oxide and as a mixed crystal.

13. Ceramic powder according to one or more of the preceding Claims 1 to 12,
which consists of pyrochlore phases A₂B₂O₇, oxides,
and sintering aids.

14. Ceramic powder according to one or more of the preceding Claims 1 to 13,
which consists of pyrochlore phases,
secondary oxides CᵣOₛ,
without sintering aids according to Claim 7.

15. Ceramic layer (13),
produced from a ceramic powder according to one or more of the preceding Claims 1 to 14,
in particular produced exclusively from a ceramic powder according to one or more of the preceding Claims 1 to 14.

16. Layer system,
comprising
a substrate (4) and
a ceramic layer (13) according to Claim 15,
which in particular constitutes the outermost layer (13).

17. Layer system according to Claim 16,
comprising
a metallic bonding layer (7),
which (7) comprises in particular an NiCoCrAlX alloy,
and in particular consists thereof.

18. Layer system according to Claim 16 or 17,
which comprises an inner ceramic layer (10),
in particular on the metallic bonding layer (7),
in particular a stabilized zirconium oxide layer,
in particular an yttrium-stabilized zirconium oxide layer, the ceramic layer (13) being present on the inner ceramic layer (10).

19. Layer system according to Claim 18,
wherein the inner layer (10) has a layer thickness of between 10% and 50%,
in particular between 10% and 40%,
of the total layer thickness of the inner layer (10) plus the outer layer (13).

20. Layer system according to Claim 18,
wherein the inner layer (10) has a layer thickness of between 10% and 30% of the total layer thickness of the inner layer (10) plus the outer layer (13).

21. Layer system according to Claim 18,
wherein the inner layer (10) has a layer thickness of between 20% and 40% of the total layer thickness of the inner layer (10) plus the outer layer (13).

22. Layer system according to Claim 18,
wherein the inner layer (10) has a layer thickness of between 50% and 90%,
in particular between 60% and 90%,
of the total layer thickness of the inner layer (10) plus the outer layer (13).

23. Layer system according to Claim 18,
wherein the inner layer (10) has a layer thickness of between 70% and 90% of the total layer thickness of the inner layer (10) plus the outer layer (13).

24. Layer system according to Claim 18,
wherein the inner layer (10) has a layer thickness of between 60% and 80% of the total layer thickness of the inner layer (10) plus the outer layer (13).

25. Layer system according to one or more of Claims 18 to 24,
wherein the inner layer (10) has a layer thickness of from 100 µm to 200 µm,
in particular 150 µm ± 50 µm.

26. Layer system according to Claim 17,
wherein the metallic bonding layer (7) has the composition (in wt%)
11% - 13% cobalt,
20% - 22% chromium,
10.5% - 11.5% aluminum,
0.3% - 0.5% yttrium,
1.5% - 2.5% rhenium and
the remainder nickel,
and in particular consists thereof.

27. Layer system according to Claim 17,
wherein the metallic bonding layer (7) has the composition (in wt%)
24% - 26% cobalt,
16% - 18% chromium,
9.5% - 11% aluminum,
0.3% - 0.5% yttrium,
1% - 1.8% rhenium and
the remainder nickel,
and in particular consists thereof.

28. Layer system according to Claim 18,
wherein the yttrium-stabilized zirconium oxide layer comprises 6 wt% - 8 wt% of yttrium.

29. Layer system according to one or more of Claims 18 to 25,
wherein the total layer thickness of the inner layer (10) plus the outer layer (13) is at least 300 µm,
in particular 300 µm.

30. Layer system according to one or more of Claims 18 to 25,
wherein the total layer thickness of the inner layer (10) plus the outer layer (13) is at least 450 µm,
in particular 450 µm.

31. Layer system according to one or more of Claims 18 to 25, wherein the total layer thickness is at most 600 µm,
in particular at most 800 µm.

32. Layer system according to one or more of the preceding claims,
which consists of a substrate (4),
a metallic layer (7),
an inner ceramic layer (10) and
an outer ceramic layer (13).

33. Layer system according to one or more of the preceding claims,
which consists of a substrate (4),
a metallic layer (7),
an oxide layer on the metallic layer (7),
an inner ceramic layer (10) and
an outer ceramic layer (13).

## Revendications

1. Poudre céramique,
qui ne comprend qu'une phase pyrochlore de formule brute A_{X}ByO_{z} avec x, y ≈ 2, z ≈ 7 et
un oxyde secondaire CᵣOₛ avec r, s > 0,
ayant une proportion de l'oxyde secondaire de 0,5 en poids à 10% en poids, dans lequel C = hafnium ( Hf ) ou dans lequel C = zirconium ( Zr ),
dans lequel B = hafnium ( Hf ) ou dans lequel B = zirconium ( Zr )
et C ≠ B.

2. Poudre céramique suivant la revendication 1,
dans lequel A = gadolinium ( Gd ).

3. Poudre céramique suivant la revendication 1, qui a au maximum 3%,
notamment au maximum 2% en poids et
d'une manière tout à fait particulière de 1,5% en poids à 2,5% en poids
d'un oxyde secondaire.

4. Poudre céramique suivant la revendication 1,
qui a au maximum 8% en poids,
notamment au maximum 6% en poids et
d'une manière tout à fait particulière de 5% en poids à 7% en poids
d'un oxyde secondaire.

5. Poudre céramique suivant la revendication 1 ou 3,
dans lequel l'oxyde secondaire est de l'oxyde d'hafnium ( HfO₂ ).

6. Poudre céramique suivant la revendication 1 ou 4,
dans lequel l'oxyde secondaire est de l'oxyde de zirconium ( ZᵣO₂ ).

7. Poudre céramique suivant l'une ou plusieurs des revendications 1 à 6,
qui comporte comme adjuvant de frittage :
jusqu'à 0,05% en poids d'oxyde de silicium,
jusqu'à 0,1% en poids d'oxyde de calcium,
jusqu'à 0,1% en poids d'oxyde de magnésium,
jusqu'à 0,1% en poids d'oxyde de fer,
jusqu'à 0,1% en poids d'oxyde d'aluminium,
jusqu'à 0,08% en poids d'oxyde de titane.

8. Poudre céramique suivant l'une ou plusieurs des revendications précédentes,
qui ne comporte qu'un oxyde CᵣOₛ secondaire.

9. Poudre céramique suivant l'une ou plusieurs des revendications précédentes,
qui ne comporte que deux oxydes CrOs et C'_{r'}O_{s'} secondaires.

10. Poudre céramique suivant l'une ou plusieurs des revendications précédentes,
dans lequel l'oxyde secondaire ou les oxydes secondaires ne sont présents que sous forme d'oxyde.

11. Poudre céramique suivant l'une ou plusieurs des revendications précédentes 1 à 10,
dans lequel l'oxyde secondaire ou les oxydes secondaires sont présents entièrement sous forme de cristallite.

12. Poudre céramique suivant l'une ou plusieurs des revendications 1 à 10,
dans lequel l'oxyde secondaire ou les oxydes secondaires se présentent à la fois sous forme d'oxyde et de cristal mixte.

13. Poudre céramique suivant l'une ou plusieurs des revendications 1 à 12,
qui est constituée de phases pyrochlore A₂B₂O₇, d'oxydes,
et d'adjuvants de frittage.

14. Poudre céramique suivant l'une ou plusieurs des revendications précédentes 1 à 13,
qui est constituée de phases pyrochlore,
d'oxydes secondaires ( CᵣOₛ )
et sans adjuvants de frittage suivant la revendication 7.

15. Couche ( 13 ) céramique,
préparée à partir d'une poudre céramique suivant l'une ou plusieurs des revendications 1 à 14 précédentes,
notamment préparée exclusivement à partir d'une poudre céramique suivant l'une ou plusieurs des revendications précédentes 1 à 14.

16. Système stratifié,
comportant
un substrat ( 4 ) et
une couche ( 13 ) céramique suivant la revendication 15, qui constitue notamment la couche ( 13 ) la plus extérieure.

17. Système stratifié suivant la revendication 16, comportant
une couche ( 7 ) métallique de liaison,
qui ( 7 ) comporte notamment un alliage en NiCoCrAlX,
en en étant notamment constituée.

18. Système stratifié suivant la revendication 16 ou 17,
qui comporte une couche ( 10 ) intérieure céramique, notamment sur la couche ( 7 ) métallique de liaison, notamment une couche d'oxyde de zirconium stabilisé, notamment une couche d'oxyde de zirconium stabilisé par de l'yttrium,
dans lequel la couche ( 13 ) céramique est présente sur la couche ( 10 ) intérieure céramique.

19. Système stratifié suivant la revendication 18,
dans lequel la couche (10) intérieure a une épaisseur représentant entre 10% et 50%,
notamment entre 10% et 40%,
de l'épaisseur totale de la couche ( 10 ) intérieure et de la couche ( 13 ) extérieure.

20. Système stratifié suivant la revendication 18,
dans lequel la couche ( 10 ) intérieure a une épaisseur représentant entre 10% et 30% de l'épaisseur totale de la couche ( 10 ) intérieure et de la couche ( 13 ) extérieure.

21. Système stratifié suivant la revendication 18,
dans lequel la couche ( 10 ) intérieure a une épaisseur représentant entre 20% et 40% de l'épaisseur totale de la couche ( 10 ) intérieure et de la couche ( 13 ) extérieure.

22. Système stratifié suivant la revendication 18,
dans lequel la couche (10) intérieure a une épaisseur représentant entre 50% et 90%,
notamment entre 60% et 90%,
de l'épaisseur totale de la couche ( 10 ) intérieure et de la couche ( 13 ) extérieure.

23. Système stratifié suivant la revendication 18,
dans lequel la couche ( 10 ) intérieure a une épaisseur représentant entre 70% et 90% de l'épaisseur totale de la couche ( 10 ) intérieure et de la couche ( 13 ) extérieure.

24. Système stratifié suivant la revendication 18,
dans lequel la couche ( 10 ) intérieure a une épaisseur représentant entre 60% et 80% de l'épaisseur totale de la couche ( 10 ) intérieure et de la couche ( 13 ) extérieure.

25. Système stratifié suivant l'une ou plusieurs des revendications 18 à 24,
dans lequel la couche ( 10 ) intérieure a une épaisseur de 100µm à 200µm,
notamment de 150µm ± 50µm.

26. Système stratifié suivant la revendication 17,
dans lequel la couche (7) métallique de liaison a la composition ( en %, en poids )
de 11% à 13% de cobalt,
de 20% à 22% de chrome,
de 10,5% à 11,5% d'aluminium,
de 0,3% à 0,5% d'yttrium,
de 1,5% à 2,5% de rhénium et
le reste étant du nickel,
en en étant notamment constituée.

27. Système stratifié suivant la revendication 17,
dans lequel la couche (7) métallique de liaison a la composition ( en %, en poids)
de 24% à 26% de cobalt,
de 16% à 18% de chrome,
de 9,5% à 11% d'aluminium,
de 0,3% à 0,5% d'yttrium,
de 1% à 1,8% de rhénium et
le reste étant du nickel,
en en étant notamment constituée.

28. Système stratifié suivant la revendication 18,
dans lequel la couche d'oxyde de zirconium stabilisé par de l'yttrium a de 6% en poids à 8% en poids d'yttrium.

29. Système stratifié suivant l'une ou plusieurs des revendications 18 à 25,
dans lequel l'épaisseur totale de la couche ( 10 ) intérieure et de la couche ( 13 ) extérieure est d'au moins 300µm, en étant notamment de 300µm.

30. Système stratifié suivant l'une ou plusieurs des revendications 18 à 25,
dans lequel l'épaisseur totale de la couche ( 10 ) intérieure et de la couche ( 13 ) extérieure est d'au moins 450µm, en étant notamment de 450µm.

31. Système stratifié suivant l'une ou plusieurs des revendications 18 à 25,
dans lequel l'épaisseur totale est au maximum de 600µm,
en étant notamment au maximum de 800µm.

32. Système stratifié suivant l'une ou plusieurs des revendications précédentes, qui est constitué d'un substrat ( 4 ),
d'une couche ( 7 ) métallique,
d'une couche ( 10 ) intérieure céramique et
d'une couche ( 13 ) extérieure céramique.

33. Système stratifié suivant l'une ou plusieurs des revendications précédentes, qui est constitué d'un substrat ( 4 ),
d'une couche ( 7 ) métallique,
d'une couche d'oxyde sur la couche ( 7 ) métallique,
d'une couche ( 10 ) intérieure céramique et
d'une couche ( 13 ) extérieure céramique.
